# EUROPEAN PATENT SPECIFICATION

(11) **EP 3 287 800 B1**
(45) Date of publication and mention of the grant of the patent: **13.10.2021**
(21) Application number: 17187846.5
(22) Date of filing: 24.08.2017
(51) Int. Cl.: G01R 31/3185

(54) **JTAG DEBUG APPARATUS AND JTAG DEBUG METHOD**
VORRICHTUNG ZUR JTAG-FEHLERBESEITIGUNG UND VERFAHREN ZUR JTAG-FEHLERBESEITIGUNG
APPAREIL DE DÉBOGAGE JTAG ET PROCÉDÉ DE DÉBOGAGE JTAG

(30) Priority: 26.08.2016 CN 201610740658
(43) Date of publication of application: 28.02.2018
(73) Proprietor: HUAWEI TECHNOLOGIES CO., LTD., Shenzhen, Guangdong 518129 (CN)
(72) Inventor: DENG, Huijuan, Shenzhen, Guangdong 518129 (CN); MA, Jin, Shenzhen, Guangdong 518129 (CN); LIU, Yu, Shenzhen, Guangdong 518129 (CN); WANG, Hao, Shenzhen, Guangdong 518129 (CN)
(74) Representative: Pfenning, Meinig & Partner mbB

(56) References cited:
- US-A1- 2008 052 582
- US-A1- 2016 047 860
- US-B1- 7 665 002

## Description

### TECHNICAL FIELD

The present invention relates to the field of chip debugging, and in particular, to a JTAG debug apparatus and a JTAG debug method.

### BACKGROUND

An SoC (System-on-Chip) is mainly debugged to facilitate chip application and development or fault trace and analysis. A JTAG (Joint Test Action Group) port is mainly used for debugging on a processor integrated into the SoC chip. A user may control, by using the JTAG port, the processor integrated into the SoC chip to execute an instruction expected by the user, and access an internal register in a CPU (central processing unit) and a device connected to a bus of the CPU, so as to access internal logic of the chip.

In addition, if the JTAG port is not properly managed, a severe threat is posed to security of data in the chip. A prior method is to add a security logic processing module between the JTAG port and a to-be-debugged unit. The method may meet a requirement of a user for enabling/disabling the JTAG port at different circulation stages of the chip. A disadvantage of the method is that after productization is performed on the chip, if fault trace and analysis need to be performed on the chip, when a debug function of the JTAG port is re-enabled, a register in the chip needs to be configured by using software and a correct password needs to be entered. If a fault on the chip is caused by the processor, when the processor cannot start, the software cannot run, and the password cannot be entered. Therefore, the JTAG port cannot be re-enabled.

US 2008/052582 A1 describes methods, apparatus, data structures, computer-readable media, mechanisms, and means for providing a JTAG to system bus interface for accessing embedded analysis system(s). JTAG commands are received and converted into commands sent out a bus to a device including an embedded analysis instrument, with results received over the bus forwarded out the JTAG interface to an external device. Such a JTAG to system bus interface may eliminate the need to provide separate JTAG TAP interfaces on each ASIC of a board, and/or eliminate the need to daisy chain multiple TAP interfaces of multiple ASICs in order to provide a single TAP interface for accessing the multiple embedded testing instruments.

### SUMMARY

During implementation of the present invention, the inventors find that the prior art has at least the following problem: how to debug internal logic of a chip without a processor.

Embodiments of the present invention are set out in the appended claims and provide a JTAG debug apparatus and a JTAG debug method, so that internal logic of a chip can be debugged with a faulty processor or without a processor.

According to a first aspect, a JTAG debug apparatus is provided, configured to debug a to-be-debugged unit in a chip. The JTAG debug apparatus includes: a TAP controller, configured to communicate with outside by using an external JTAG port, and generate, based on a signal received from the JTAG port, a debug signal including an address of the to-be-debugged unit and a debug instruction, where the debug signal is a JTAG port signal based on the JTAG protocol; a signal conversion unit, configured to receive the debug signal that is output from the TAP controller, and convert the debug signal from the JTAG port signal to a bus slave port signal that can access a slave port of the to-be-debugged unit; and a bus, configured to obtain the debug signal that is converted to the bus slave port signal and that is output from the signal conversion unit, and transmit, based on the debug signal, the debug instruction to the to-be-debugged unit indicated by the address of the to-be-debugged unit.

According to the foregoing JTAG debug apparatus, the debug signal is converted from the JTAG port signal to the bus slave port signal that can access the slave port of the to-be-debugged unit, and the bus uses the debug signal converted to the bus slave port signal to perform a read/write operation on the to-be-debugged unit, so as to implement debugging. Debugging is implemented on internal logic of a chip without a processor. Therefore, even though the processor is faulty, debugging can still be performed on the internal logic of the chip.

Optionally, the signal conversion unit converts a signal from the bus slave port signal to the JTAG port signal, and outputs the JTAG port signal from the JTAG port by using the TAP controller, where the signal is received from the to-be-debugged unit by using the bus. According to the foregoing JTAG debug apparatus, bi-directional conversion between the JTAG port signal and the bus slave port signal is implemented by using the signal conversion unit, so that the JTAG debug apparatus smoothly debugs the to-be-debugged unit.

Optionally, the bus may be an APB bus, an AXI bus, an AHB bus, or the like. For example, when the bus is the APB bus, the APB bus transmits, based on the AMBA protocol, the debug instruction to the slave port of the to-be-debugged unit indicated by the address of the to-be-debugged unit, so as to perform the read/write operation on the slave port of the to-be-debugged unit.

The JTAG debug apparatus further includes a non-volatile memory, a loading unit, and a security logic processing unit. The non-volatile memory stores security configuration information, the loading unit automatically loads the security configuration information stored in the non-volatile memory to the security logic processing unit when the chip is powered on, and the security logic processing unit outputs an enable signal based on the loaded security configuration information, so as to control whether access to the to-be-debugged unit from the JTAG port by using the TAP controller and the signal conversion unit is allowed. According to the above, the to-be-debugged unit can be securely accessed without a processor.

Optionally, the security configuration information includes a security level, a password, and a chip identifier.

Optionally, the security level includes a low security level, an intermediate security level, and a high security level. The security logic processing unit is configured to: when the security level is the low security level, allow a user to access the to-be-debugged unit by using the JTAG port without restriction; when the security level is the intermediate security level, allow the user to access the to-be-debugged unit by using the JTAG port with a correct password entered; and when the security level is the high security level, prohibit the user from accessing the to-be-debugged unit by using the JTAG port.

Optionally, the JTAG debug apparatus further includes a first AND circuit. An input terminal of the first AND circuit receives the enable signal, the other input terminal receives the debug signal that is in the JTAG port signal and that is output from the TAP controller, and a signal that is output from the first AND circuit is transmitted to the signal conversion unit.

Optionally, the JTAG debug apparatus further includes a second AND circuit. An input terminal of the second AND circuit receives the enable signal, the other input terminal receives a debug result signal that is converted to the JTAG port signal and that is output from the signal conversion unit, and a signal that is output from the second AND circuit is transmitted to the TAP controller.

According to a second aspect, a JTAG debug method is provided, used to debug a to-be-debugged unit in a chip. The JTAG debug method includes: receiving a signal from a JTAG port, and generating, based on the received signal, a debug signal including an address of the to-be-debugged unit and a debug instruction, where the debug signal is a JTAG port signal based on the JTAG protocol; converting the debug signal from the JTAG port signal to a bus slave port signal that can access a slave port of the to-be-debugged unit; and transmitting, by using a bus and based on the debug signal converted to the bus slave port signal, the debug instruction to the to-be-debugged unit indicated by the address of the to-be-debugged unit.

According to the foregoing JTAG debug method, the debug signal is converted from the JTAG port signal to the bus slave port signal that can access the slave port of the to-be-debugged unit, and the bus may use the debug signal converted to the bus slave port signal to perform a read/write operation on the to-be-debugged unit, so as to implement debugging. Debugging is implemented on internal logic of a chip without a processor. Therefore, even though the processor is faulty, debugging can still be performed on the internal logic of the chip.

Optionally, the method further includes: converting a signal from the bus slave port signal to the JTAG port signal, and outputting the JTAG port signal to the JTAG port, where the signal is received from the to-be-debugged unit by using the bus. According to the foregoing JTAG debug method, bi-directional conversion between the JTAG port signal and the bus slave port signal is implemented by using a signal conversion unit, so that the to-be-debugged unit is smoothly debugged.

The method further includes: automatically loading security configuration information when the chip is powered on, and outputting an enable signal based on the security configuration information, so as to control whether access to the to-be-debugged unit from the JTAG port is allowed.

Optionally, the security configuration information includes a security level, a password, and a chip identifier.

Optionally, the method further includes: when the security level is a low security level, allowing a user to access the to-be-debugged unit by using the JTAG port without restriction; when the security level is an intermediate security level, allowing the user to access the to-be-debugged unit by using the JTAG port with a correct password entered; and when the security level is a high security level, prohibiting the user from accessing the to-be-debugged unit by using the JTAG port.

According to the foregoing technical solutions in the embodiments of the present invention, a debug signal including an address of a to-be-debugged unit and a debug instruction is converted from a JTAG port signal to a bus slave port signal, and the debug instruction is transmitted, by using a bus, to the to-be-debugged unit indicated by the address of the to-be-debugged unit, so that internal logic of a chip is debugged without a processor. Therefore, the internal logic of the chip can still be debugged even with a faulty processor.

### BRIEF DESCRIPTION OF DRAWINGS

To describe the technical solutions in the embodiments of the present invention more clearly, the following briefly describes the accompanying drawings required for describing the embodiments of the present invention. Apparently, the accompanying drawings in the following description show merely some embodiments of the present invention, and a person of ordinary skill in the art may still derive other drawings from these accompanying drawings without creative efforts.
FIG. 1 is a schematic block diagram of a JTAG debug apparatus according to an embodiment of the present invention;
FIG. 2 is a schematic block diagram of a JTAG debug apparatus according to another embodiment of the present invention;
FIG. 3 is a flowchart of a JTAG debug method according to an embodiment of the present invention; and
FIG. 4 is a flowchart of a JTAG debug method according to another embodiment of the present invention.

### DESCRIPTION OF EMBODIMENTS

To make the objectives, technical solutions, and advantages of the embodiments of the present invention clearer, the following describes the technical solutions in the embodiments of the present invention with reference to the accompanying drawings in the embodiments of the present invention. Apparently, the described embodiments are a part rather than all of the embodiments of the present invention. All other embodiments obtained by a person of ordinary skill in the art based on the embodiments of the present invention without creative efforts shall fall within the protection scope of the present invention.

At present, the examples of implementations are described comprehensively with reference to the accompanying drawings. However, the examples of implementations may be implemented in multiple forms, and it should not be understood as being limited to the examples of implementations described herein. Conversely, the implementations are provided to make the present invention more comprehensive and complete, and comprehensively convey the idea of the examples of the implementations to a person skilled in the art. A same reference numeral in the accompanying drawings represents same or similar components or units, and therefore repeated descriptions of the components or units are appropriately omitted.

In addition, the described features or structures may be combined in one or more embodiments in any appropriate manner. In the following descriptions, a lot of specific details are provided to give a comprehensive understanding of the embodiments of the present invention. However, a person of ordinary skill in the art should be aware that, the technical solutions in the present invention may be implemented without one or more of the particular details, or another unit or method may be used. In other cases, well-known structures or operations are not shown or described in detail, in order not to obscure the main technical idea of the present invention.

It should be note that, provided that no conflict is caused, the embodiments in this application or the features in the embodiments may be combined together. This application is described in detail in the following with reference to the accompanying drawings by using embodiments.

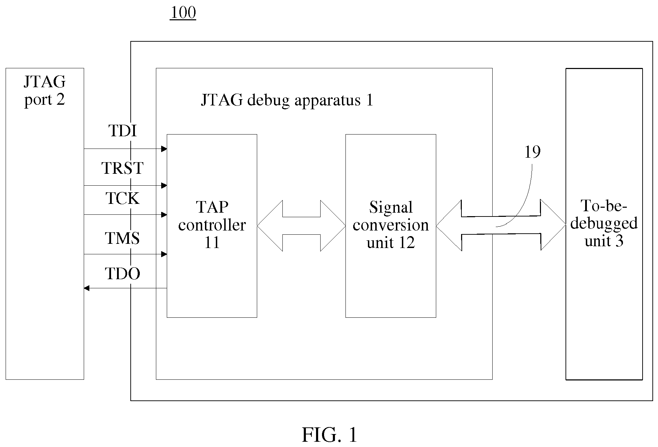

FIG. 1 is a schematic block diagram of a JTAG debug apparatus according to an embodiment of the present invention. A system on chip (System on Chip, SoC) 100 includes a JTAG debug apparatus 1 and a to-be-debugged unit 3. Signals are input and output between a user and the JTAG debug apparatus 1 by using a JTAG port 2, and the JTAG debug apparatus 1 communicates with the to-be-debugged unit 3, so as to debug the to-be-debugged unit 3.

The JTAG port 2 includes a clock input line TCK, a data input line TDI, a data output line TDO, a mode selection line TMS, and a reset line TRST. Data used for debugging is input from the JTAG port 2 by using the data input line TDI. Data of a debug result is output from the JTAG port 2 by using the data output line TDO. The mode selection line TMS is used to set the JTAG port 2 to a particular mode. The reset line TRST is optional and is active low.

The JTAG debug apparatus 1 shown in FIG. 1 is configured to debug the to-be-debugged unit 3 in the chip. The JTAG debug apparatus 1 includes: a TAP controller 11, configured to communicate with outside by using the external JTAG port 2, and generate, based on a signal received from the JTAG port 2, a debug signal including an address of the to-be-debugged unit and a debug instruction, where the debug signal is a JTAG port signal based on the JTAG protocol; a signal conversion unit 12, configured to receive the debug signal that is output from the TAP controller 11, and convert the debug signal from the JTAG port signal to a bus slave port signal that can access a slave port of the to-be-debugged unit; and a bus 19, configured to obtain the debug signal that is converted to the bus slave port signal and that is output from the signal conversion unit 12, and transmit the debug instruction to the to-be-debugged unit 3 indicated by the address of the to-be-debugged unit. The following provides a detailed description.

The TAP (Test Access Port, test access port) controller 11 is configured in the chip 100 according to the JTAG protocol, and a signal is input from the JTAG port 2. The TAP controller 11 selects, according to the signal that is input from the JTAG port 2, whether a password is to be entered, a status/data is to be output, the to-be-debugged unit is to be accessed or started, or the like. The TAP controller 11 generates, based on the signal received from the JTAG port signal 2, a debug signal including an address of the to-be-debugged unit and a debug instruction. The debug signal is a JTAG port signal based on the JTAG protocol. The address of the to-be-debugged unit indicates a to-be-accessed unit. The debug instruction is used to indicate an operation to be performed on the to-be-accessed unit, for example, a write instruction or a read instruction. The TAP controller 11 sets a debug mode based on the signal that is input from the JTAG port 2, so as to control debugging on the to-be-debugged unit 3.

The signal conversion unit 12 obtains the debug signal from the TAP controller 11, and converts the debug signal from the JTAG port signal to a bus slave port signal that can access the slave port of the to-be-debugged unit. In addition, the signal conversion unit 12 can also convert a subsequently received bus slave port signal to a JTAG port signal, so as to implement mutual conversion between the JTAG port signal and the bus slave port signal. The signal conversion unit 12 converts the debug signal that is input from the TAP controller 11, that is, the JTAG port signal, to the bus slave port signal. In addition, the signal conversion unit 12 converts the signal that is output from the to-be-debugged unit 3, that is, the bus slave port signal, to the JTAG port signal, and outputs the JTAG port signal to the TAP controller 11, to output the JTAG port signal to the outside by using the JTAG port 2.

The JTAG port signal herein is a signal that is input to the TAP controller or that is output from the TAP controller, and is a bi-directional signal. The signal is input from the JTAG port or output to the JTAG port, and is a signal that can be transmitted by using the JTAG port and that is based on the JTAG port protocol.

The bus 19 obtains the debug signal that is converted to the bus slave port signal and that is output from the signal conversion unit 12, and transmits the debug instruction to the to-be-debugged unit 3 indicated by the address of the to-be-debugged unit. After the debug signal is input to the bus 19, the bus 19 selects the to-be-debugged unit 3 according to the address of the to-be-debugged unit that is included in the debug signal, and transmits the debug instruction included in the debug signal to a bus slave port that is connected to the bus and that is of the selected to-be-debugged unit, so as to debug the to-be-debugged unit 3. For example, the debug instruction is a write instruction, and the write instruction is input to the bus slave port of the to-be-debugged unit 3 indicated by the address of the to-be-debugged unit, so as to perform a write operation on the to-be-debugged unit 3. Alternatively, the debug instruction is a read instruction, and the read instruction is input to the bus slave port of the to-be-debugged unit 3 indicated by the address of the to-be-debugged unit, so as to perform a read operation on the to-be-debugged unit 3.

The bus slave port signal is a bi-directional signal, and is a signal that can access the slave port of the to-be-debugged unit. The to-be-debugged unit 3 connected to the bus 19 has the bus slave port (which is not shown in FIG. 1), and the to-be-debugged unit 3 may be debugged by controlling the bus slave port. In other words, internal logic of the to-be-debugged unit 3 may be accessed only when a signal of the bus slave port is controlled. The bus, for example, may be such a bus as an APB bus, an AHB bus, or an AXI bus that can access the slave port based on the AMBA protocol. However, the bus is not particularly limited, provided that the bus can access the slave port of the to-be-debugged unit.

That a general timer is used as the to-be-debugged unit is used as a specific example for description. Generally, the general timer further includes an AMBA APB bus (a peripheral bus) slave port in addition to a clock signal, a reset signal, an interrupt signal, and the like. By controlling the APB bus slave port, an initial count value or a count mode (one-shot, periodic count, or the like) of the general timer may be set, or a current count vale and an interrupt status may be read. The debug signal that includes the address of the to-be-debugged unit and the debug instruction and that is generated by the TAP controller is converted from the JTAG port signal to the bus slave port signal by using the signal conversion unit. The APB bus selects, based on the AMBA protocol, a general timer indicated by the address of the to-be-debugged unit that is included in the debug signal converted by the signal conversion unit, and outputs the debug instruction to a bus slave port that is connected to the APB bus and that is of the general timer, so that the bus slave port of the general timer can be accessed, thereby implementing a read/write operation in the general timer to implement debugging.

According to the foregoing JTAG debug apparatus, a debug signal is converted from a JTAG port signal to a bus slave port signal that can access a slave port of to-be-debugged unit, and a bus uses the debug signal converted to the bus slave port signal to debug the to-be-debugged unit. Therefore, the JTAG port signal does not need to be converted to an instruction that controls a processor, but is directly converted to the bus slave port signal. In this way, the JTAG debug apparatus debugs a unit connected to the bus without a processor in an SoC system. Therefore, the unit connected to the bus and in the SoC can still be debugged even with a faulty processor or without a processor.

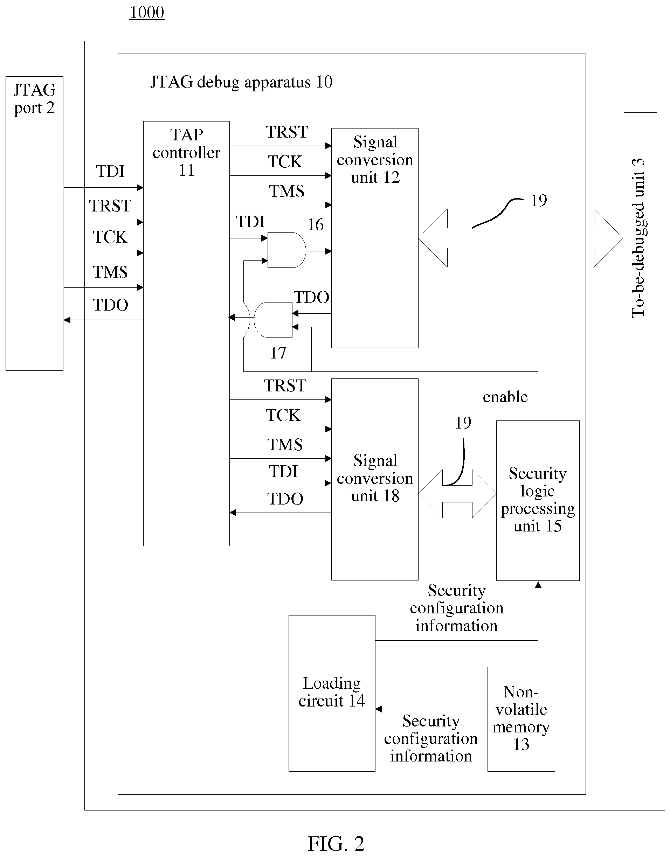

Optionally, in another embodiment, FIG. 2 is a schematic block diagram of a JTAG debug apparatus according to another embodiment of the present invention. Different from Embodiment 1, in Embodiment 2, the JTAG debug apparatus further includes a security protection unit. In FIG. 2, a part that is the same as that in Embodiment 1 is marked by using a same numeral and a detailed description of the part is omitted. Embodiment 2 is described in the following.

A system chip 1000 includes a JTAG debug apparatus 10 and a to-be-debugged unit 3. The JTAG debug apparatus 10 includes a TAP controller 11, signal conversion units 12 and 18, a non-volatile memory 13, a loading circuit 14, a security logic processing unit 15, and two-input AND gates 16 and 17.

As shown in FIG. 2, the non-volatile memory 13, the loading circuit 14, the security logic processing unit 15, and the two-input AND gates 16 and 17 constitute a security protection unit for the to-be-debugged unit 3, so as to prevent a person that has no permission from maliciously accessing the to-be-debugged unit, or stealing or tampering information in the to-be-debugged unit.

The non-volatile memory 13 is a storage medium that stores security configuration information. The security configuration information may include a security level, a password, and a chip identifier of the to-be-debugged unit.

The security level herein reflects a restriction mode in accessing the to-be-debugged unit 3, and includes the following security levels in ascending order: a low security level, that is, an open mode, in which a user may access the to-be-debugged unit 3 by using a JTAG port 2 without restriction; an intermediate security level, that is, a password-based protection mode, in which the user may access the to-be-debugged unit 3 by using the JTAG port 2 only when a correct password is entered; and a high security level, that is, a prohibited mode, in which the user may access the to-be-debugged unit 3 by using the JTAG port 2 under no circumstance.

The password is in one-to-one correspondence with the chip identifier. Each chip has a unique chip identifier. Because each chip has a unique password, the chip identifier may be associated with the password, to facilitate personalized management on the password.

The security level and the chip identifier are information that may be disclosed. The user may obtain the security level and the chip identifier of the to-be-debugged unit by using the JTAG port under any circumstance, to access the to-be-debugged unit by an appropriate security means.

An authorized user may rewrite the security level in the non-volatile memory 13, and the rewriting is restricted to only from a low security level to a high security level, and is irreversible. In addition, even the authorized user is not allowed to modify the chip identifier and the password.

In an optional embodiment, the non-volatile memory 13 may be an OTP (One Time Programmable, one time programmable) memory. Because of a one-time-programmable feature of the OTP memory, no security configuration information in the OTP memory may be modified. In addition, the non-volatile memory may be in multiple forms provided that it is ensured that the security configuration information cannot be modified.

The loading circuit 14 automatically reads the security configuration information from the non-volatile memory 13 when the chip is powered on, and configures the security configuration information to the security logic processing unit 15 without software, that is, without a processor.

When the loading circuit 14 automatically configures the security configuration information to the security logic processing unit 15, the security logic processing unit 15 records the security configuration information loaded from the loading circuit 14. The security logic processing unit 15 includes a security level register, a password register, and a chip identifier register.

The foregoing registers are disposed in the security logic processing unit 15, so that the signal conversion unit 12 reads the chip identifier, writes a password, and reads a determining result that indicates whether the entered password is correct.

The security logic processing unit 15 determines a security level according to the security configuration information from the loading circuit 14 and the input from the signal conversion unit 18, and outputs an enable signal. The enable signal allows or prohibits debugging on the to-be-debugged unit 3 by using the JTAG port 2. When the security level is the low security level, an enable signal "1" (an active level) is output, to enable an access path from the JTAG port 2 to the to-be-debugged unit 3. When the security level indicates the prohibited mode, an enable signal "0" (an inactive level) is output, to disable an access path from the JTAG port 2 to the to-be-debugged unit 3. When the security level indicates the password-based protection mode, it is determined whether the entered password is consistent with the loaded password stored in the security logic processing unit 15. If the entered password is consistent with the loaded password stored in the security logic processing unit 15, an enable signal "1" is output, to enable the access path from the JTAG port 2 to the to-be-debugged unit 3. If the entered password is inconsistent with the loaded password stored in the security logic processing unit 15, an enable signal "0" is output, to disable the access path from the JTAG port 2 to the to-be-debugged unit 3.

On a path from the JTAG port 2 to the security logic processing unit 15, at any security level, the security logic processing unit 15 may be accessed by using the JTAG port 2, the TAP controller 11, and the signal conversion unit 18. The access is not affected by the enable signal. Therefore, at any security level, the chip identifier register in the security logic processing unit 15 may be read by using the JTAG port 2 without restriction, and the password register in the security logic processing unit 15 may also be configured. The chip identifier register is read-only, and the password register is write-only. The security logic processing unit 15 does not include sensitive information of the user, thereby effectively avoiding leaking the information from the JTAG port 2 and the security logic processing unit 15. The signal conversion unit 18 herein is the same as the signal conversion unit 12, and is configured to perform conversion between the JTAG port signal and the bus slave port signal. Details are not described herein again.

The signal conversion unit 12 is located between the TAP controller 11 and the to-be-debugged unit 3. The two-input AND circuit 16 is located between the TAP controller 11 and the signal conversion unit 12. An input terminal of the two-input AND circuit 16 receives an enable signal, and the other input terminal receives a debug data input signal TDI that is in the JTAG port signal and that is output from the TAP controller 11. A signal that is output from the two-input AND circuit 16 is transmitted to the signal conversion unit 12. The two-input AND circuit 16 can restrict input to the to-be-debugged unit 3 from the JTAG port 2.

The two-input AND circuit 17 is located between the signal conversion unit 12 and the TAP controller 11. An input terminal of the two-input AND circuit 17 receives an enable signal, and the other input terminal receives a debug result output signal TDO that is in the JTAG port signal and that is output from the signal conversion unit 12. A signal that is output from the two-input AND circuit 17 is transmitted to the TAP controller 11. The two-input AND gate 17 can restrict output of data in the to-be-debugged unit 3 from the JTAG port.

Specifically, when the chip is powered on, the security configuration information that includes the security level, the password, and the chip identifier and that is stored in the non-volatile memory 13 is loaded to the security logic processing unit 15 by using the loading unit 14. The security level is stored in the security level register, and the chip identifier is stored in the chip identifier register. The user may read the chip identifier in the chip identifier register in the security logic processing unit 15 by using the JTAG port 2, the TAP controller 11, and the signal conversion unit 18. The security logic processing unit 15 determines the security level. When the security level is the low security level, the security logic processing unit 15 outputs an enable signal "1", and the user can directly debug the to-be-debugged unit 3 by using the TAP controller 11, the two-input AND circuits 16 and 17, and the signal conversion unit 12. When the security level is the intermediate security level, the security logic processing unit 15 determines whether a password entered by the user into the password register by using the JTAG port 2 is consistent with the stored password. When the entered password is consistent with the stored password, an enable signal "1" is output, and the user can debug the to-be-debugged unit 3 by using the TAP controller 11, the two-input AND circuit 16 and 17, and the signal conversion unit 12. When the entered password is inconsistent with the stored password, an enable signal "0" is output, and the user cannot debug the to-be-debugged unit 3 by using the TAP controller 11, the two-input AND circuit 16 and 17, and the signal conversion unit 12. The enable signal herein is not particularly limited provided that the signal can be used to prohibit or allow debugging. When the security level is the high security level, the security logic processing unit 15 outputs an enable signal "0", and the user cannot debug the to-be-debugged unit 3 by using the TAP controller 11, the two-input AND circuits 16 and 17, and the signal conversion unit 12.

When the foregoing security authentication succeeds, the signal conversion unit 12 converts a JTAG port signal to a bus slave port signal. The bus slave port signal is a bi-directional signal. On one hand, by converting the JTAG port signal to the bus slave port signal, the to-be-debugged unit 3 may be accessed, and an input signal used for debugging may be input. On the other hand, a status signal and the like of the to-be-debugged unit 3 may be used as a bus slave port signal and output to the signal conversion unit 12, then is converted to a JTAG port signal by using the signal conversion unit 12, and is output from the TAP controller 11.

In an optional embodiment, only one signal conversion unit may be set. In the foregoing embodiment, two signal conversion units are disposed, but not necessary. Because the to-be-debugged unit 3 and the security logic processing unit 15 may be distinguished by using different addresses, only one signal conversion unit may be set. It can be determined, based on the different addresses, whether the to-be-debugged unit 3 or the security logic processing unit 15 is to be accessed.

In addition, there may be multiple to-be-debugged units, and the multiple to-be-debugged units may be distinguished by using different addresses.

A security protection unit is disposed for the JTAG debug apparatus 10, which can prevent external malicious access to the to-be-debugged unit 3, and prevent information from being stolen or tampered, thereby securely debugging the to-be-debugged unit 3 in the chip.

The JTAG debug apparatus in the embodiments of the present invention is described above. A working process of JTAG debugging is described in the following.

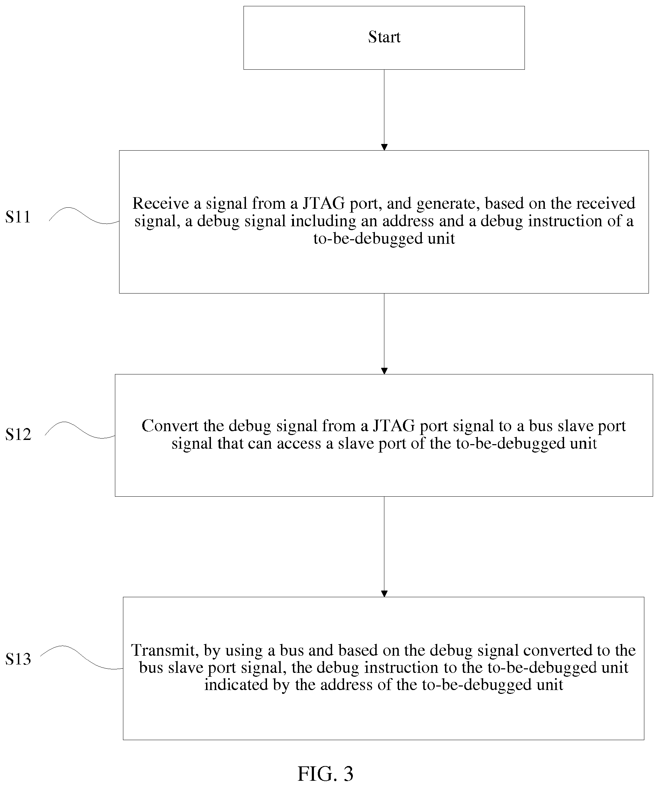

FIG. 3 is a flowchart of a JTAG debug method according to an embodiment of the present invention. A working process of JTAG debugging is described in the following with reference to FIG. 3.

A JTAG debug method, used to debug a to-be-debugged unit in a chip, includes; Step S11: Receive a signal from a JTAG port, and generate, based on the received signal, a debug signal including an address of the to-be-debugged unit and a debug instruction, where the debug signal is a JTAG port signal based on the JTAG protocol. Step S12: Convert the debug signal from the JTAG port signal to a bus slave port signal that can access a slave port of the to-be-debugged unit. Step S13: Transmit, by using a bus and based on the debug signal converted to the bus slave port signal, the debug instruction to the to-be-debugged unit indicated by the address of the to-be-debugged unit.

Specifically, in the foregoing JTAG debug apparatus, the TAP controller receives a signal from an external JTAG port, and generates, based on the received signal, a debug signal including an address of the to-be-debugged unit and a debug instruction. The signal conversion unit converts the debug signal received from the TAP controller 11 from a JTAG port signal to a bus slave port signal. For example, when the bus is an APB bus, the APB bus transmits, based on the AMBA protocol, the debug instruction to the to-be-debugged unit indicated by the address of the to-be-debugged unit.

In addition, the signal conversion unit further converts a signal from the bus slave port signal to the JTAG port signal, and outputs the JTAG port signal from the JTAG port by using the TAP controller, where the signal is received from the to-be-debugged unit by using the bus. In addition, the signal conversion unit further converts the bus slave port signal received from the to-be-debugged unit to the JTAG port signal, and outputs the JTAG port signal to the JTAG port.

According to the foregoing debug method, internal logic of a chip can be debugged with a faulty processor or without a processor.

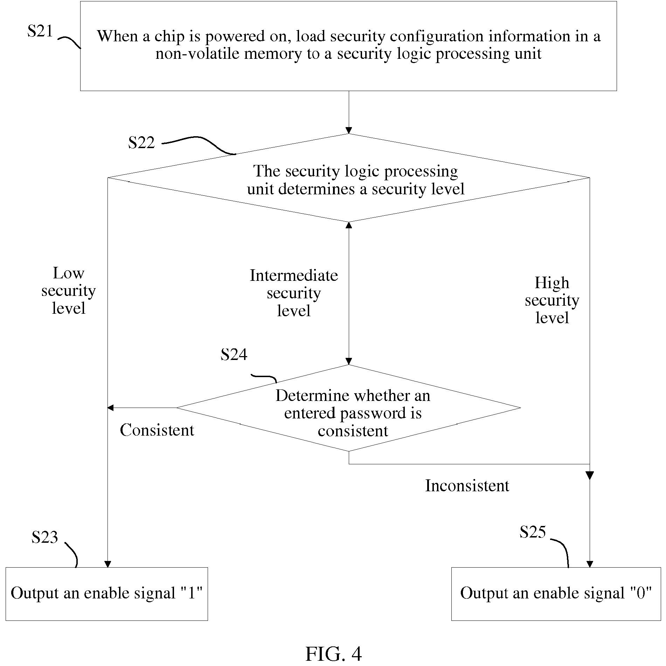

FIG. 4 is a flowchart of a JTAG debug method according to another embodiment of the present invention. Based on the debug method shown in FIG. 3, the following operations are further performed.

Security configuration information is programmed into the non-volatile memory in advance. As shown in step S21, when the chip is powered on, the security configuration information in the non-volatile memory is loaded to a security logic processing unit. As shown in step S22, the security logic processing unit determines a security level. When the security level is a low security level, as shown in step S23, the security logic processing unit outputs an enable signal "1". When the security level is an intermediate security level, as shown in step S24, the security logic processing unit determines whether an entered password is consistent with a password in the security configuration information. When the entered password is consistent with the password in the security configuration information, as shown in step S23, the security logic processing unit outputs an enable signal "1". When the entered password is inconsistent with the password in the security configuration information, as shown in step S25, the security logic processing unit outputs an enable signal "0". When the security level is a high security level, as shown in step S25, the security logic processing unit outputs an enable signal "0". When the enable signal is "1", a user is allowed to access the to-be-debugged unit by using the JTAG port. When the enable signal is "0", the user is not allowed to debug the to-be-debugged unit by using the JTAG port.

In addition, the user may read a chip identifier register in the security logic processing unit by using the JTAG port. The user writes the password to a password register in the security logic processing unit by using the JTAG port according to the chip identifier. The password register is compared with the password loaded to the non-volatile memory.

Security protection steps are set in the JTAG debug method, which can prevent external malicious access to a to-be-debugged unit, and prevent information from being stolen or tampered, thereby securely debugging the to-be-debugged unit in a chip.

It should be clear that the present invention is not limited to the particular configuration and processing that are described above and shown in the figures. In addition, for brevity, detailed description of the known method and structures are omitted herein. In the foregoing embodiments, some specific structures and steps are described and shown as examples. However, the method process of the present invention is not limited to the specific structures and steps that are described and shown, and a person skilled in the art may make various changes, modifications, or additions, or change an order between steps after understanding the spirit of the present invention.

A person of ordinary skill in the art may be aware that, in combination with the examples described in the embodiments disclosed in this specification, units and algorithm steps may be implemented by electronic hardware, computer software, or a combination thereof. To clearly describe the interchangeability between the hardware and the software, the foregoing has generally described compositions and steps of each example according to functions. Whether the functions are performed by hardware or software depends on particular applications and design constraint conditions of the technical solutions. A person skilled in the art may use different methods to implement the described functions for each particular application, but it should not be considered that the implementation goes beyond the scope of the present invention.

It may be clearly understood by a person skilled in the art that, for the purpose of convenient and brief description, for a detailed working process of the foregoing system, apparatus, and unit, reference may be made to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces, indirect couplings or communication connections between the apparatuses or units, or electrical connections, mechanical connections, or connections in other forms.

The units described as separate parts may or may not be physically separate, and parts displayed as units may or may not be physical units, may be located in one position, or may be distributed on a plurality of network units. A part or all of the units may be selected according to actual needs to achieve the objectives of the solutions of the embodiments of the present invention.

In addition, functional units in the embodiments of the present invention may be integrated into one processing unit, or each of the units may exist alone physically, or two or more units are integrated into one unit. The integrated unit may be implemented in a form of hardware, or may be implemented in a form of a software functional unit.

The foregoing descriptions are merely specific embodiments of the present invention, but are not intended to limit the protection scope of the present invention. Any modification or replacement readily figured out by a person skilled in the art within the technical scope disclosed in the present invention shall fall within the protection scope of the present invention. Therefore, the protection scope of the present invention shall be subject to the protection scope of the claims.

## Claims

1. A Joint Test Action Group, JTAG, debug apparatus, configured to debug a to-be-debugged unit (3) in a chip, wherein the JTAG debug apparatus comprises:
a Test Access Port, TAP, controller (11), configured to communicate with outside by using an external JTAG port (2), and generate, based on a signal received from the JTAG port (2), a debug signal comprising an address of the to-be-debugged unit and a debug instruction, wherein the debug signal is a JTAG port signal based on the JTAG protocol;
a signal conversion unit (12), configured to receive the debug signal that is output from the TAP controller (11), and convert the debug signal from the JTAG port signal to a bus slave port signal that can access a slave port of the to-be-debugged unit (3); and
a bus (19), configured to obtain the debug signal that is converted to the bus slave port signal and that is output from the signal conversion unit (12), and transmit, based on the debug signal, the debug instruction to the to-be-debugged unit indicated by the address of the to-be-debugged unit (3); said JTAG debug apparatus is **characterised by**
further comprising a non-volatile memory (13), a loading unit (14), and a security logic processing unit (15), wherein
the non-volatile memory (13) stores security configuration information;
the loading unit (14) automatically loads the security configuration information stored in the non-volatile memory (13) to the security logic processing unit (15) when the chip is powered on; and
the security logic processing unit (15) outputs an enable signal based on the loaded security configuration information, so as to control whether access to the to-be-debugged unit (3) from the JTAG port (2) by using the TAP controller (11) and the signal conversion unit (12) is allowed.

2. The JTAG debug apparatus according to claim 1, wherein
the signal conversion unit (12) converts a signal from the bus slave port signal to the JTAG port signal, and outputs the JTAG port signal from the JTAG port (2) by using the TAP controller (11), wherein the signal is received from the to-be-debugged unit (3) by using the bus (19).

3. The JTAG debug apparatus according to claim 1, wherein
the security configuration information comprises a security level, a password, and a chip identifier.

4. The JTAG debug apparatus according to claim 1, wherein
the security level comprises a low security level, an intermediate security level, and a high security level; and
the security logic processing unit (15) is configured to: when the security level is the low security level, allow a user to access the to-be-debugged unit (3) by using the JTAG port (2) without restriction; when the security level is the intermediate security level, allow the user to access the to-be-debugged unit (3) by using the JTAG port (2) with a correct password entered; and when the security level is the high security level, prohibit the user from accessing the to-be-debugged unit (3) by using the JTAG port (2).

5. The JTAG debug apparatus according to claim 1, further comprising a first AND circuit (16), wherein an input terminal of the first AND circuit receives the enable signal, the other input terminal receives the debug signal that is output from the TAP controller (11), and a signal that is output from the first AND circuit (16) is transmitted to the signal conversion unit (12).

6. The JTAG debug apparatus according to claim 1, further comprising a second AND circuit (17), wherein an input terminal of the second AND circuit (17) receives the enable signal, the other input terminal receives a debug result signal that is converted to the JTAG port signal and that is output from the signal conversion unit (12), and a signal that is output from the second AND circuit (17) is transmitted to the TAP controller (11).

7. A Joint Test Action Group, JTAG, debug method, used to debug a to-be-debugged unit in a chip, and comprising the following steps:
receiving (S11) a signal from a JTAG port, and generating, based on the received signal, a debug signal comprising an address of the to-be-debugged unit and a debug instruction, wherein the debug signal is a JTAG port signal based on the JTAG protocol;
converting (S12) the debug signal from the JTAG port signal to a bus slave port signal that can access a slave port of the to-be-debugged unit; and
transmitting (S13), by using a bus and based on the debug signal converted to the bus slave port signal, the debug instruction to the to-be-debugged unit indicated by the address of the to-be-debugged unit; said JTAG debug method is **characterised by**
automatically loading (S21) security configuration information when the chip is powered on, and outputting (S23) an enable signal based on the security configuration information, so as to control whether access to the to-be-debugged unit from the JTAG port is allowed.

8. The JTAG debug method according to claim 7, further comprising:
converting a signal from the bus slave port signal to the JTAG port signal, and outputting the JTAG port signal to the JTAG port, wherein the signal is received from the to-be-debugged unit by using the bus.

9. The JTAG debug method according to claim 7, wherein
the security configuration information comprises a security level, a password, and a chip identifier.

10. The JTAG debug method according to claim 9, further comprising:
when the security level is a low security level, allowing a user to access the to-be-debugged unit by using the JTAG port without restriction; when the security level is an intermediate security level, allowing the user to access the to-be-debugged unit by using the JTAG port with a correct password entered; and when the security level is a high security level, prohibiting the user from accessing the to-be-debugged unit by using the JTAG port.

## Patentansprüche

1. Joint-Test-Action-Group-, JTAG-, Fehlersuch-("Debugging"-)vorrichtung, die zum Debuggen einer zu debuggenden Einheit (3) in einem Chip gestaltet ist, wobei die JTAG-"Debugging"-Vorrichtung umfasst:
eine Testzugangsanschluss-, Test-Access-Port-, TAP-, Steuerung (11), die dazu gestaltet ist, unter Verwendung eines externen JTAG-"Ports" (2) mit außen zu kommunizieren und basierend auf einem Signal, das von dem JTAG-"Port" (2) empfangen wird, ein "Debugging"-Signal, das eine Adresse der zu debuggenden Einheit umfasst, und eine "Debugging"-Anweisung zu erzeugen, wobei das "Debugging"-Signal ein JTAG-"Port"-Signal basierend auf dem JTAG-Protokoll ist;
eine Signalumwandlungseinheit (12), die dazu gestaltet ist, das "Debugging"-Signal zu empfangen, das von der TAP-Steuerung (11) ausgegeben wird, und das "Debugging"-Signal von dem JTAG-"Port"-Signal in ein Bus-"Slave-Port"-Signal umzuwandeln, das auf einen "Slave-Port" der zu debuggenden Einheit (3) zugreifen kann; und
einen Bus (19), der dazu gestaltet ist, das "Debugging"-Signal zu beziehen, das in das Bus-"Slave-Port"-Signal umgewandelt ist und das von der Signalumwandlungseinheit (12) ausgegeben wird, und basierend auf dem "Debugging"-Signal die "Debugging"-Anweisung an die zu debuggende Einheit zu übertragen, die mittels der Adresse der zu debuggenden Einheit (3) angegeben ist;
wobei die JTAG-"Debugging"-Vorrichtung **dadurch gekennzeichnet ist, dass** sie ferner einen nicht-flüchtigen Speicher (13), eine Ladeeinheit (14) und eine Sicherheitslogik-Verarbeitungseinheit (15) umfasst, wobei
der nicht-flüchtige Speicher (13) Sicherheitskonfigurationsinformationen speichert, die Ladeeinheit (14) automatisch die in dem nicht-flüchtigen Speicher (13) gespeicherten Sicherheitskonfigurationsinformationen in die Sicherheitslogik-Verarbeitungseinheit (15) lädt, wenn der Chip eingeschaltet ist, und
die Sicherheitslogik-Verarbeitungseinheit (15) basierend auf den geladenen Sicherheitskonfigurationsinformationen ein Freigabesignal ausgibt, um zu steuern, ob der Zugriff auf die zu debuggende Einheit (3) von dem JTAG-"Port" (2) aus unter Verwendung der TAP-Steuerung (11) und der Signalumwandlungseinheit (12) gestattet ist.

2. JTAG-"Debugging"-Vorrichtung nach Anspruch 1, wobei
die Signalumwandlungseinheit (12) ein Signal von dem Bus-"Slave-Port"-Signal in das JTAG-"Port"-Signal umwandelt und das JTAG-"Port"-Signal unter Verwendung der TAP-Steuerung (11) von dem JTAG-"Port" (2) ausgibt, wobei das Signal von der zu debuggenden Einheit (3) unter Verwendung des Buses (19) empfangen wird.

3. JTAG-"Debugging"-Vorrichtung nach Anspruch 1, wobei
die Sicherheitskonfigurationsinformationen eine Sicherheitsstufe, ein Passwort und eine Chipkennung umfassen.

4. JTAG-"Debugging"-Vorrichtung nach Anspruch 1, wobei
die Sicherheitsstufe eine niedrige Sicherheitsstufe, eine mittlere Sicherheitsstufe und eine hohe Sicherheitsstufe umfasst und
die Sicherheitslogik-Verarbeitungseinheit (15) zu Folgendem gestaltet ist: wenn die Sicherheitsstufe die niedrige Sicherheitsstufe ist, Gestatten des Zugriffs auf die zu debuggende Einheit (3) für einen Nutzer unter Verwendung des JTAG-"Ports" (2) ohne Einschränkung; wenn die Sicherheitsstufe die mittlere Sicherheitsstufe ist, Gestatten des Zugriffs auf die zu debuggende Einheit (3) für den Nutzer unter Verwendung des JTAG-"Ports" (2) mit einem eingegebenen korrekten Passwort; und wenn die Sicherheitsstufe die hohe Sicherheitsstufe ist, Verbieten des Zugriffs auf die zu debuggende Einheit (3) unter Verwendung des JTAG-"Ports" (2) für den Nutzer.

5. JTAG-"Debugging"-Vorrichtung nach Anspruch 1, ferner eine erste AND-Schaltung (16) umfassend, wobei ein Eingangsanschluss der ersten AND-Schaltung das Freigabesignal empfängt, der andere Eingangsanschluss das "Debugging"-Signal empfängt, das von der TAP-Steuerung (11) ausgegeben wird, und ein Signal, das von der ersten AND-Schaltung (16) ausgegeben wird, zu der Signalumwandlungseinheit (12) übertragen wird.

6. JTAG-"Debugging"-Vorrichtung nach Anspruch 1, ferner eine zweite AND-Schaltung (17) umfassend, wobei ein Eingangsanschluss der zweiten AND-Schaltung (17) das Freigabesignal empfängt, der andere Eingangsanschluss ein "Debugging"-Ergebnissignal empfängt, das in das JTAG-"Port"-Signal umgewandelt ist und das von der Signalumwandlungseinheit (12) ausgegeben wird, und ein Signal, das von der zweiten AND-Schaltung (17) ausgegeben wird, zu der TAP-Steuerung (11) übertragen wird.

7. Joint-Test-Action-Group-, JTAG-, Fehlersuch-("Debugging"-)verfahren, das zum Debuggen einer zu debuggenden Einheit in einem Chip verwendet wird und die folgenden Schritte umfasst:
Empfangen (S11) eines Signals von einem JTAG-"Port" und basierend auf dem empfangenen Signal Erzeugen eines "Debugging"-Signals, das eine Adresse der zu debuggenden Einheit umfasst, und einer "Debugging"-Anweisung, wobei das "Debugging"-Signal ein JTAG-"Port"-Signal basierend auf dem JTAG-Protokoll ist;
Umwandeln (S12) des "Debugging"-Signals von dem JTAG-"Port"-Signal in ein Bus-"Slave-Port"-Signal, das auf einen "Slave-Port" der zu debuggenden Einheit zugreifen kann; und
Übertragen (S13) der "Debugging"-Anweisung an die zu debuggende Einheit, die mittels der Adresse der zu debuggenden Einheit angegeben ist, unter Verwendung eines Buses und basierend auf dem in das Bus-"Slave-Port"-Signal umgewandelte "Debugging"-Signal; wobei das JTAG-"Debugging"-Verfahren **gekennzeichnet ist durch**
automatisches Laden (S21) von Sicherheitskonfigurationsinformationen, wenn der Chip eingeschaltet wird, und Ausgeben (S23) eines Freigabesignals basierend auf den Sicherheitskonfigurationsinformationen, um zu steuern, ob der Zugriff auf die zu debuggende Einheit von dem JTAG-"Port" aus gestattet wird.

8. JTAG-"Debugging"-Verfahren nach Anspruch 7, ferner umfassend:
Umwandeln eines Signals von dem Bus-"Slave-Port"-Signal in das JTAG-"Port"-Signal und Ausgeben des JTAG-"Port"-Signals an den JTAG-"Port", wobei das Signal von der zu debuggenden Einheit unter Verwendung des Buses empfangen wird.

9. JTAG-"Debugging"-Verfahren nach Anspruch 7, wobei
die Sicherheitskonfigurationsinformationen eine Sicherheitsstufe, ein Passwort und eine Chipkennung umfassen.

10. JTAG-"Debugging"-Verfahren nach Anspruch 9, ferner umfassend:
wenn die Sicherheitsstufe eine niedrige Sicherheitsstufe ist, Gestatten des Zugriffs auf die zu debuggende Einheit für einen Nutzer unter Verwendung des JTAG-"Ports" ohne Einschränkung; wenn die Sicherheitsstufe eine mittlere Sicherheitsstufe ist, Gestatten des Zugriffs auf die zu debuggende Einheit für den Nutzer unter Verwendung des JTAG-"Ports" mit einem eingegebenen korrekten Passwort; und wenn die Sicherheitsstufe eine hohe Sicherheitsstufe ist, Verbieten des Zugriffs auf die zu debuggende Einheit unter Verwendung des JTAG-"Ports" für den Nutzer.

## Revendications

1. Appareil de débogage JTAG (Joint Test Action Group), configuré pour déboguer une unité à déboguer (3) dans une puce, l'appareil de débogage JTAG comprenant :
un contrôleur de port d'accès de test, TAP, (11), configuré pour communiquer avec l'extérieur en utilisant un port JTAG externe (2), et générer, sur la base d'un signal reçu à partir du port JTAG (2), un signal de débogage comprenant une adresse de l'unité à déboguer et une instruction de débogage, dans lequel le signal de débogage est un signal de port JTAG basé sur le protocole JTAG ;
une unité de conversion de signal (12), configurée pour recevoir le signal de débogage qui est sorti du contrôleur TAP (11), et convertir le signal de débogage du signal de port JTAG en un signal de port esclave de bus qui peut accéder à un port esclave de l'unité à déboguer (3) ; et
un bus (19), configuré pour obtenir le signal de débogage qui est converti en signal de port esclave de bus et qui est sorti de l'unité de conversion de signal (12), et transmettre, sur la base du signal de débogage, l'instruction de débogage à l'unité à déboguer indiquée par l'adresse de l'unité à déboguer (3) ; ledit appareil de débogage JTAG est **caractérisé par**
**le fait qu'**il comprend en outre une mémoire non volatile (13), une unité de chargement (14), et une unité de traitement logique de sécurité (15), dans lequel la mémoire non volatile (13) stocke des informations de configuration de sécurité ;
l'unité de chargement (14) charge automatiquement les informations de configuration de sécurité stockées dans la mémoire non volatile (13) dans l'unité de traitement logique de sécurité (15) lorsque la puce est mise sous tension ; et
l'unité de traitement logique de sécurité (15) sort un signal de validation sur la base des informations de configuration de sécurité chargées, de manière à contrôler si l'accès à l'unité à déboguer (3) à partir du port JTAG (2) en utilisant le contrôleur TAP (11) et l'unité de conversion de signal (12) est autorisé.

2. Appareil de débogage JTAG selon la revendication 1, dans lequel l'unité de conversion de signal (12) convertit un signal du signal de port esclave de bus en signal de port JTAG, et sort le signal de port JTAG du port JTAG (2) en utilisant le contrôleur TAP (11), dans lequel le signal est reçu à partir de l'unité à déboguer (3) en utilisant le bus (19).

3. Appareil de débogage JTAG selon la revendication 1, dans lequel les informations de configuration de sécurité comprennent un niveau de sécurité, un mot de passe, et un identifiant de puce.

4. Appareil de débogage JTAG selon la revendication 1, dans lequel
le niveau de sécurité comprend un niveau de sécurité faible, un niveau de sécurité intermédiaire et un niveau de sécurité élevé ; et
l'unité de traitement logique de sécurité (15) est configurée pour : lorsque le niveau de sécurité est le niveau de sécurité faible, permettre à un utilisateur d'accéder à l'unité à déboguer (3) en utilisant le port JTAG (2) sans restriction ; lorsque le niveau de sécurité est le niveau de sécurité intermédiaire, permettre à l'utilisateur d'accéder à l'unité à déboguer (3) en utilisant le port JTAG (2) avec un mot de passe correct saisi ; et lorsque le niveau de sécurité est le niveau de sécurité élevé, interdire à l'utilisateur d'accéder à l'unité à déboguer (3) en utilisant le port JTAG (2).

5. Appareil de débogage JTAG selon la revendication 1, comprenant en outre un premier circuit ET (16), dans lequel une borne d'entrée du premier circuit ET reçoit le signal de validation, l'autre borne d'entrée reçoit le signal de débogage qui est sorti du contrôleur TAP (11), et un signal qui est sorti du premier circuit ET (16) est transmis à l'unité de conversion de signal (12).

6. Appareil de débogage JTAG selon la revendication 1, comprenant en outre un second circuit ET (17), dans lequel une borne d'entrée du second circuit ET (17) reçoit le signal de validation, l'autre borne d'entrée reçoit un signal de résultat de débogage qui est converti en signal de port JTAG et qui est sorti de l'unité de conversion de signal (12), et un signal qui est sorti du second circuit ET (17) est transmis au contrôleur TAP (11).

7. Procédé de débogage JTAG (Joint Test Action Group), utilisé pour déboguer une unité à déboguer dans une puce, et comprenant les étapes suivantes :
recevoir (S 11) un signal à partir d'un port JTAG, et générer, sur la base du signal reçu, un signal de débogage comprenant une adresse de l'unité à déboguer et une instruction de débogage, dans lequel le signal de débogage est un signal de port JTAG basé sur le protocole JTAG ;
convertir (S 12) le signal de débogage du signal de port JTAG en un signal de port esclave de bus qui peut accéder à un port esclave de l'unité à déboguer ; et
transmettre (S 13), en utilisant un bus et sur la base du signal de débogage converti en signal de port esclave de bus, l'instruction de débogage à l'unité à déboguer indiquée par l'adresse de l'unité à déboguer ; ledit procédé de débogage JTAG est **caractérisé par** le fait de
charger automatiquement (S21) des informations de configuration de sécurité lorsque la puce est mise sous tension, et sortir (S23) un signal de validation basé sur les informations de configuration de sécurité, de manière à contrôler si l'accès à l'unité à déboguer à partir du port JTAG est autorisé.

8. Procédé de débogage JTAG selon la revendication 7, comprenant en outre :
convertir un signal du signal de port esclave de bus en signal de port JTAG, et sortir le signal de port JTAG vers le port JTAG, dans lequel le signal est reçu à partir de l'unité à déboguer en utilisant le bus.

9. Procédé de débogage JTAG selon la revendication 7, dans lequel les informations de configuration de sécurité comprennent un niveau de sécurité, un mot de passe, et un identifiant de puce.

10. Procédé de débogage JTAG selon la revendication 9, comprenant en outre :
lorsque le niveau de sécurité est un niveau de sécurité faible, permettre à un utilisateur d'accéder à l'unité à déboguer en utilisant le port JTAG sans restriction ; lorsque le niveau de sécurité est un niveau de sécurité intermédiaire, permettre à l'utilisateur d'accéder à l'unité à déboguer en utilisant le port JTAG avec un mot de passe correct saisi ; et lorsque le niveau de sécurité est un niveau de sécurité élevé, interdire à l'utilisateur d'accéder à l'unité à déboguer en utilisant le port JTAG.
